# FASCICULE DE BREVET EUROPEEN

(11) **EP 1 281 978 B1**
(45) Date de publication et mention de la délivrance du brevet: **15.04.2009**
(21) Numéro de dépôt: 02291688.6
(22) Date de dépôt: 05.07.2002
(51) Int. Cl.: G01R 31/12

(54) **Procédé et dispositif de test d'un module de puissance**
Verfahren und Vorrichtung zur Prüfung eines Leistungsmoduls
Method and device for testing a power module

(30) Priorité: 02.08.2001 FR 0110388
(43) Date de publication de la demande: 05.02.2003
(73) Titulaire: ALSTOM Transport SA, 92300 Levallois-Perret (FR)
(72) Inventeur: Dutarde, Emmanuel, 65800 Aureilhan (FR); Breit, Fabrice, 64710 Campan (FR); Saiz, José, 33150 Cenon (FR); Dinculescu, Sorin, 31000 Toulouse (FR); Lebey, Thierry, 31830 Plaisance du Touch (FR)

(56) Documents cités:
- US-A- 5 523 620

## Description

L'invention se rapporte à un procédé de test d'un module de puissance et plus particulièrement à un procédé de test permettant de vérifier l'état correct de l'isolement d'un module de puissance. L'invention s'applique notamment aux tests des modules de puissances destinés à équiper un convertisseur de puissance embarqué sur un véhicule ferroviaire. L'invention concerne également un dispositif pour la mise en oeuvre du procédé de test selon l'invention.

Il est connu, du US 5 523 620 ou de la norme CEI (Commission Electrotechnique Internationale) 1287-1, une méthode de test de convertisseurs de puissance embarqués sur un véhicule ferroviaire ayant pour but de vérifier l'état correct de l'isolement d'un convertisseur complètement assemblé. Dans cette méthode, les bornes principales du convertisseur aussi bien que les collecteurs, émetteurs et grilles de commande de tous les composants semi-conducteurs sont reliés entre eux. Le niveau des décharges partielles est ensuite mesuré lorsqu'on applique une tension alternative ou une tension continue entre les bornes connectées ensembles et la semelle métallique sur laquelle repose le substrat diélectrique supportant les composants du module de puissance.

Une telle méthode de test présente l'inconvénient de ne tester que l'isolation liée au substrat, ce qui ne représente qu'une partie de l'empilement diélectrique utilisé dans les modules de puissance, les isolations liées par exemple à l'encapsulation des composants n'étant pas testées.

Aussi, un but de la présente invention est donc de proposer un procédé de test d'un module de puissance, simple et économique à réaliser, permettant de détecter les éventuels problèmes de décharges partielles dans le gel diélectrique recouvrant les composants de puissance ainsi que les problèmes de décharges partielles entre les bornes de puissance ou à l'interface entre les différents matériaux diélectriques.

A cet effet, l'invention a pour objet un procédé de test d'un module de puissance comportant au moins un composant de puissance disposé sur un substrat diélectrique, une diode étant associée en parallèle et en position inverse avec le composant de puissance, le module de puissance comportant une grille de commande, un émetteur et un collecteur, caractérisé en ce qu'on mesure les décharges partielles apparaissant entre l'émetteur et le collecteur lorsque l'on connecte une source de tension alternative superposée à une source de tension continue entre l'émetteur et le collecteur du module de puissance, la tension Vtest reçue par le module de puissance entre le collecteur et l'émetteur vérifiant à chaque instant Vtest > 0, le composant de puissance étant pendant ce test maintenu à l'état bloqué au moyen d'une source de tension continue connectée entre la grille de commande et l'émetteur.

Selon une autre caractéristique de l'invention, le module de puissance comporte plusieurs composants de puissance connectés en parallèle, une diode étant associée en parallèle et en position inverse avec chaque composant de puissance, le module de puissance comportant plusieurs émetteurs, plusieurs collecteurs et une grille de commande commune, le procédé de test étant caractérisé en ce qu'on mesure les décharges partielles apparaissant entre les émetteurs, reliées électriquement entre eux, et les collecteurs, reliés électriquement entre eux, lorsque l'on connecte une source de tension alternative superposée à une source de tension continue entre les émetteurs et les collecteurs du module de puissance, la tension Vtest reçue par le module de puissance entre les collecteurs et les émetteurs vérifiant à chaque instant Vtest > 0 de manière à ce que les diodes ne passent jamais en conduction naturelle, les modules de puissance étant pendant ce test maintenus à l'état bloqué au moyen d'une source de tension continue connectée entre de la grille de commande commune et les émetteurs.

Selon encore une autre caractéristique de l'invention, les composants de puissance sont des composants IGBT.

L'invention concerne également un dispositif de test d'un module de puissance pour la mise en oeuvre du procédé précédemment décrit, caractérisé en ce qu'il comporte deux bornes alimentées par une source de tension alternative superposée à une source de tension continue, la tension Vtest entre les deux bornes vérifiant à chaque instant Vtest >0 et en ce qu'il comporte des moyens pour mesurer les décharges partielles entre les deux bornes.

Selon une autre caractéristique de l'invention, les deux bornes sont alimentées par un générateur de tension continue disposé en série avec un générateur de tension alternative.

Selon une autre caractéristique de l'invention, les deux bornes sont alimentées par un générateur de tension continue disposé en parallèle avec un générateur de tension alternative.

Selon une autre caractéristique de l'invention, les bornes d'alimentation sont respectivement reliées à un premier circuit reliant entre eux les différents collecteurs du module de puissance et un second circuit reliant entre eux les différents émetteurs du module de puissance.

On comprendra mieux les buts, aspects et avantages de la présente invention, d'après la description donnée ci-après d'un mode particulier de réalisation de l'invention, présenté à titre d'exemple non limitatif, en se référant aux dessins annexés, dans lesquels :
- la figure 1 est une vue schématique d'un module de puissance testé suivant un procédé de test conforme à la norme CEI 1287-1 ;
- la figure 2 représente isolément, et de manière schématique, un composant de puissance de type IGBT équipant le module de puissance de la figure 1 ;
- la figure 3 est une vue schématique du module de puissance de la figure 1 testé au moyen d'un premier mode de réalisation du dispositif de test selon l'invention ;
- la figure 4 est une vue schématique du module de puissance de la figure 1 testé au moyen d'un second mode de réalisation du dispositif de test selon l'invention.

Pour faciliter la lecture du dessin, seuls les éléments nécessaires à la compréhension de l'invention ont été représentés. Les mêmes éléments portent les mêmes références d'une figure à l'autre.

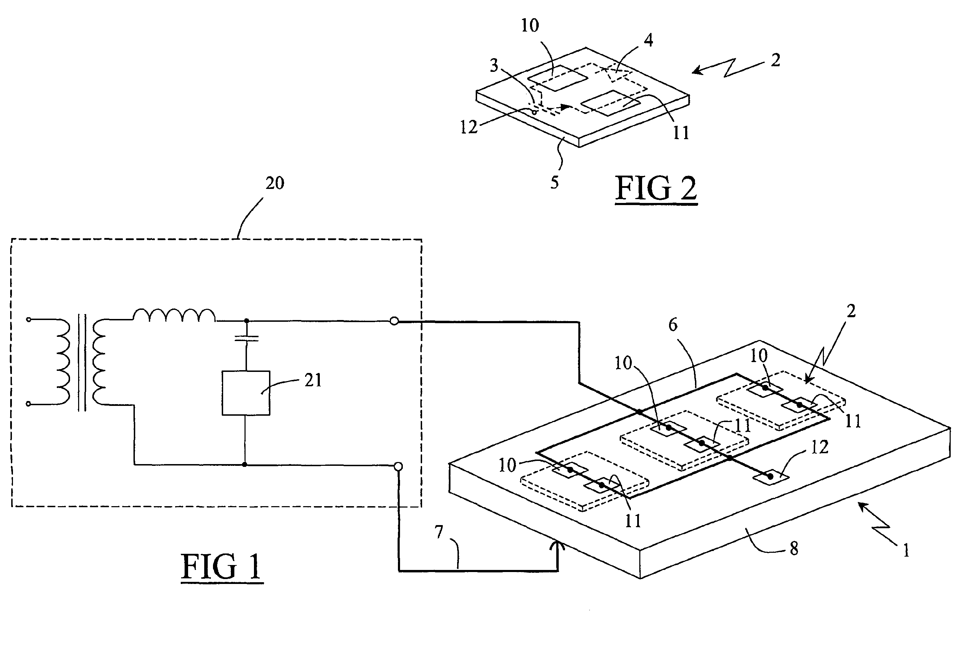

La figure 1 représente un module de puissance 1, destiné à équiper un convertisseur de puissance embarqué sur un véhicule ferroviaire, testé suivant un procédé de l'art antérieur conforme à la norme CEI 1287-1.

Le module de puissance 1 destiné à être testé comporte trois éléments de puissance 2 montés électriquement en parallèle et reposant sur une semelle métallique 8. Chaque élément de puissance 2, représenté isolément et plus en détail sur la figure 2, comporte un substrat diélectrique 5 sur lequel repose un composant IGBT 3 et une diode 4 associée en parallèle, en position inverse, la diode 4 permettant la réversibilité du courant au sein du module 1. Les composants IGBT 3 et les diodes 4 sont recouverts de manière classique d'un gel diélectrique.

Chaque composant IGBT 3 est muni d'un collecteur 10, d'un émetteur 11, et comporte de manière classique une grille de commande 12 permettant de mettre à l'état bloqué ou à l'état passant le composant de puissance 3. Les grilles de commande 12 des trois composants IGBT 3 sont reliées entre elles de manière à présenter une borne commune, disposées latéralement sur le module de puissance 1 représenté à la figure 1, commandant l'état bloqué ou passant des trois composants IGBT 3.

Dans le procédé de test suivant la norme CEI 1287-1, toutes les connexions du module de puissance, à savoir les collecteurs 10, les émetteurs 11 et la borne 12 des grilles de commande, sont reliées entre elles par un premier circuit 6. Une tension est ensuite appliquée, au moyen d'un dispositif de test 20, entre le premier circuit 6 et un second circuit 7 mis en contact avec la semelle métallique 8, le dispositif 20 fournissant, dans l'exemple représenté, une tension alternative. Le niveau de décharge est simultanément mesuré entre le premier circuit 6 et le second circuit 7 au moyen d'un appareil de mesure 21. Un tel procédé de test présente l'inconvénient de ne tester que l'isolation liée aux substrats diélectriques 5.

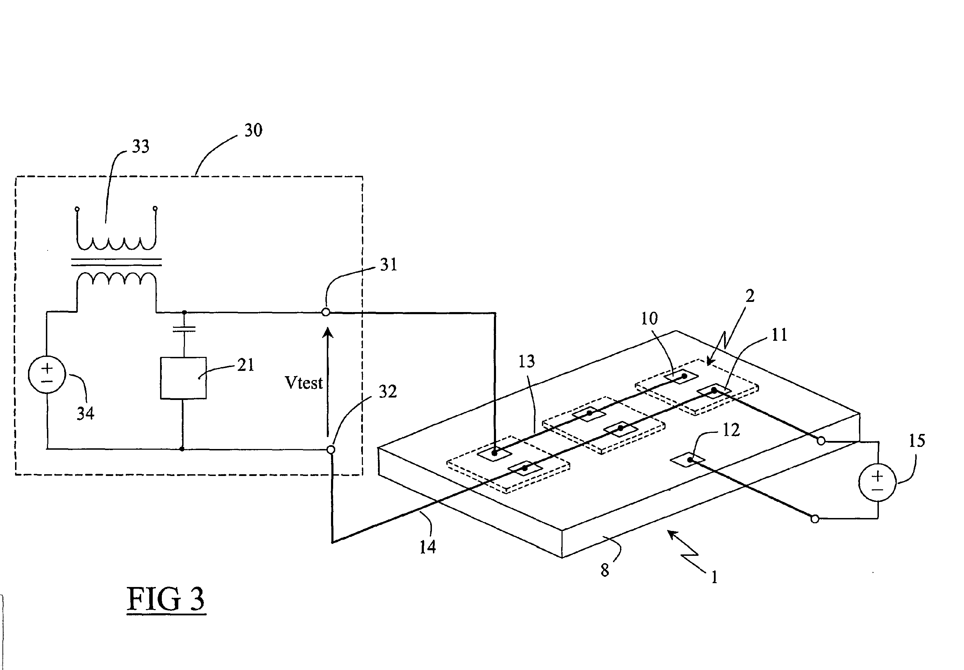

La figure 3 représente le module de puissance 1 de la figure 1 testé suivant un mode particulier de réalisation du procédé de test selon l'invention. Conformément à cette figure, les collecteurs 10 du module de puissance sont reliés électriquement entre eux au moyen d'un premier circuit 13 qui est connecté à une première borne 31 d'un dispositif de test 30. Les émetteurs 11 du module de puissance 1 sont reliés électriquement entre eux au moyen d'un second circuit 14 qui est connecté à une seconde borne 32 du dispositif de test 30, ce dernier comportant entre ces deux borne 31, 32 un générateur 33 de tension alternative disposé en série avec un générateur 34 de tension continue. Les valeurs des tensions du générateur de tension alternative 33 et du générateur de tension continue 34 sont telles que l'on a, à chaque instant, la tension Vtest entre les bornes 31 et 32 qui vérifie Vtest > 0 de manière à tester le module de puissance sous une tension variable jamais négative afin d'éviter que les diodes 4 ne passent en conduction naturelle ce qui rendrait impossible la mesure des décharges partielles. Une tension continue est appliquée, au moyen d'un générateur 15, entre la borne 12 des grilles de commande et les émetteurs 11, reliés entre eux par le second circuit 14, de manière à mettre dans l'état bloqué les composants IGBT 3 des trois éléments de puissance 2 du module 1. Lorsque toutes ces conditions d'alimentation électrique sont vérifiées, on mesure les décharges partielles entre le premier circuit 13 et le second circuit 14 au moyen d'un appareil de mesure classique 21.

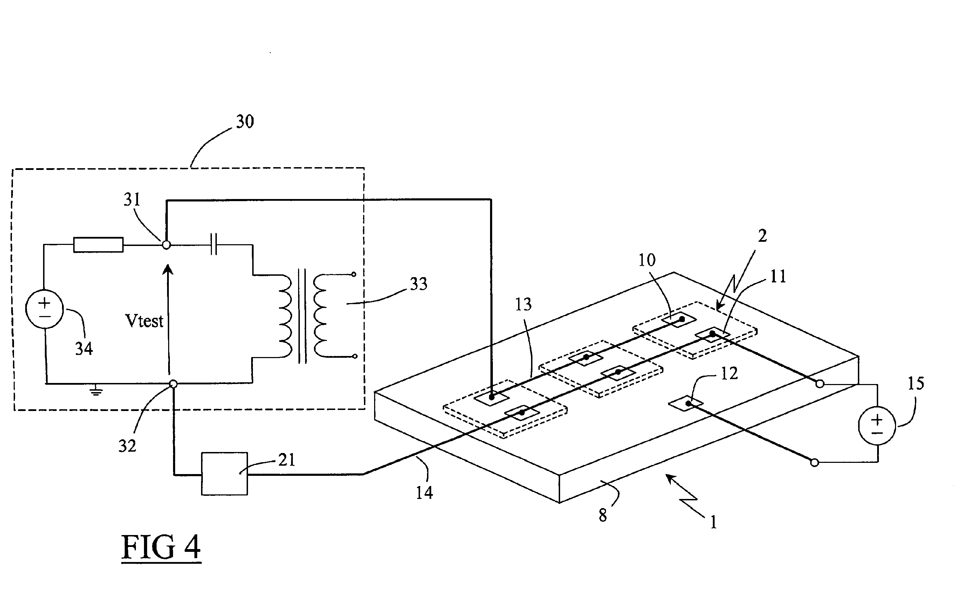

La figure 4 représente une variante de réalisation du dispositif de test 30 se différentiant du dispositif représenté à la figure 3 par le fait que, entre les bornes 31 et 32, le générateur 34 de tension continue est disposé en parallèle avec le générateur 33 de tension alternative, les générateurs 33 et 34 étant dimensionnés de telle sorte que la tension Vtest entre les bornes 31 et 32 vérifie à chaque instant Vtest > 0. Dans cette variante de réalisation, l'appareil 21 de mesure des décharges partielles est disposé entre la borne 32 du dispositif de test 30 et le second circuit 14 qui est relié aux émetteurs 11 du module de puissance. La borne 31 reste reliée directement au premier circuit 13 et le procédé de test reste inchangé par rapport à celui décrit à la figure 3.

Un tel procédé de test présente l'avantage de permettre la détection des décharges partielles dues à l'encapsulation des composants de puissance. Ainsi, le procédé de test selon l'invention permet la détection des décharges partielles dans le gel diélectrique, entre les fils de soudage émetteur et la métallisation collecteur, entre les bornes de puissance ou à l'interface entre les différents matériaux diélectriques, par exemple au niveau de la liaison entre le gel et la résine époxy.

De plus, ce procédé de test présente l'avantage de mesurer les décharges partielles dans des conditions proches de celles rencontrées lors de l'utilisation effective du module de puissance.

Un tel procédé de test, qui reste très simple à mettre en oeuvre, peut avantageusement être utilisé pour le suivi des évolutions dans le temps des grandeurs caractéristiques d'un module de puissance en vue d'une maintenance prédictive.

Bien entendu, l'invention n'est nullement limitée au mode de réalisation décrit et illustré qui n'a été donné qu'à titre d'exemple. Des modifications restent possibles, notamment du point de vue de la constitution des divers éléments ou par substitution d'équivalents techniques, sans sortir pour autant du domaine de protection de l'invention.

## Revendications

1. Procédé de test d'un module de puissance (1) comportant au moins un composant de puissance (3) disposé sur un substrat diélectrique (5), une diode (4) étant associée en parallèle et en position inverse avec ledit composant de puissance (3), ledit module de puissance (1) comportant une grille de commande (12), un émetteur (11) et un collecteur (10), **caractérisé en ce qu'**on mesure les décharges partielles apparaissant entre l'émetteur (11) et le collecteur (10) lorsque l'on connecte une source de tension alternative superposée à une source de tension continue entre le collecteur (10) et l'émetteur (11) du module de puissance, une tension Vtest reçue par le module de puissance (1) entre le collecteur (10) et l'émetteur (11) vérifiant à chaque instant Vtest > 0 de manière à ce que la diode (4) ne passe jamais en conduction naturelle, le composant de puissance (3) étant pendant le test maintenu à l'état bloqué au moyen d'une source de tension continue connectée entre la grille de commande (12) et l'émetteur (11).

2. Procédé de test d'un module de puissance (1) selon la revendication 1, ledit module (1) comportant plusieurs composants de puissance (3) connectés en parallèle, une diode (4) étant associée en parallèle et en position inverse avec chaque composant de puissance (3), le module de puissance (1) comportant plusieurs émetteurs (11), plusieurs collecteurs (10) et une grille de commande (12) commune, **caractérisé en ce qu'**on mesure les décharges partielles apparaissant entre les émetteurs (11), reliées électriquement entre eux, et les collecteurs (10), reliés électriquement entre eux, lorsque l'on connecte la source de tension alternative superposée à la source de tension continue entre les émetteurs (11) et les collecteurs (10) des composants de puissance, la tension Vtest reçue par les composants de puissance (1) entre les collecteurs (10) et les émetteurs (11) vérifiant à chaque instant Vtest >0 de manière à ce que les diodes (4) ne passent jamais en conduction naturelle, les composants de puissance (3) étant pendant le test maintenus à l'état bloqué au moyen de la source de tension continu connectée entre la grille de commande (12) commune et les émetteurs (11).

3. Procédé de test d'un module de puissance selon l'une quelconque des revendications 1 à 2, **caractérisé en ce que** ledit au moins un composant de puissance (3) sont des composants IGBT.

4. Dispositif de test d'un module de puissance (1) pour la mise en oeuvre du procédé selon l'une quelconque des revendications 1 à 3, **caractérisé en ce qu'**il comporte deux bornes (31, 32) alimentées par la source de tension alternative superposée à la source de tension continue, la tension Vtest entre les bornes (31) et (32) vérifiant à chaque instant Vtest >0, et **en ce qu'**il comporte des moyens (21) pour mesurer les décharges partielles entre les deux bornes (31, 32).

5. Dispositif de test selon la revendication 4, **caractérisé en ce que** les deux bornes (31, 32) sont alimentées par un générateur (34) de tension continue disposé en série avec un générateur (33) de tension alternative.

6. Dispositif de test selon la revendication 4, **caractérisé en ce que** les deux bornes (31,32) sont alimentées par un générateur (34) de tension continue disposé en parallèle avec un générateur (33) de tension alternative.

7. Dispositif de test selon l'une quelconque des revendications 4 à 6, **caractérisé en ce que** lesdites bornes d'alimentation (31, 32) sont respectivement reliées à un premier circuit (13) reliant entre eux les différents collecteurs (10) du module de puissance (1) et un second circuit (14) reliant entre eux les différents émetteurs (11) du module de puissance (1).

## Claims

1. A method for testing a power module (1) comprising at least one power component (3) arranged on a dielectric substrate (5), a diode (4) connected in antiparallel with the said power component (3), the power module (1) comprising a control gate (12), an emitter (11) and a collector (10), **characterised in that** partial discharges are measured, the said partial discharges occurring between the emitter (11) and the collector (10) when an alternating current voltage source superimposed on a direct current voltage source is connected between the collector (10) and the emitter (11) of the power module, a voltage Vtest received by the power module (1) between the collector (10) and the emitter (11) ensures at every moment that the condition Vtest>0 is met in such a way that the diode (4) never conducts naturally, the power component (3) being maintained in a turned off state during the test by means of a direct current voltage source connected between the control gate (12) and the emitter (11).

2. A method for testing a power module (1) according to claim 1, the said module (1) comprising a plurality of power components (3) connected in parallel, a diode (4) being connected in antiparallel with each power component (3), the power module (1) comprising a plurality of emitters (11), a plurality of collectors (10) and a common control gate (12), **characterised in that** partial discharges are measured, the said partial discharges occurring between the mutually electrically connected emitters (11) and the mutually electrically connected collectors (10) when the alternating current voltage source superimposed on the direct current voltage source is connected between the emitters (11) and the collectors (10) of the power components, the voltage Vtest received by the power components (1) between the collectors (10) and the emitters (11) ensuring at every moment that the condition Vtest>0 is met in such a way that the diodes (4) never conduct naturally, the power components (3) being maintained in a turned off state during the test by means of the direct current voltage source connected between the common control gate (12) and the emitters (11).

3. A method for testing a power module according to either claim 1 or claim 2, **characterised in that** the said at least one power component (3) is an an IGBT.

4. A device for testing a power module (1) for implementing the method according to any one of claims 1 - 3, **characterised in that** it comprises two terminals (31, 32) supplied with the alternating current voltage source superimposed on the direct current voltage source, the voltage Vtest between the terminals (31) and (32) ensuring at every moment that the condition Vtest>0 is met, and **in that** it comprises means (21) for measuring the partial discharges between the two terminals (31, 32).

5. A test device according to claim 4, **characterised in that** the two terminals (31, 32) are supplied by a direct current voltage generator (34) arranged in series with an alternating current voltage generator (33).

6. A test device according to claim 4, **characterised in that** the two terminals (31, 32) are are supplied by a direct current voltage generator (34) arranged in parallel with an alternating current voltage generator (33).

7. A test device according to any one of claims 4 - 6, **characterised in that** the said supply terminals (31, 32) are respectively connected to a first circuit (13) for connecting together the various collectors (10) of the power module (1) and to a second circuit (14) for connecting together the various emitters (11) of the power module (1).

## Patentansprüche

1. Verfahren zur Prüfung eines Leistungsmoduls (1), das wenigstens ein auf einem Dielektrikumsubstrat (5) angeordnetes Leistungselement (3), eine parallel und invers zu dem Leistungselement (3) angeordnete Diode (4) aufweist, wobei das Leistungsmodul (1) ein Steuer-Gate (12), einen Emitter (11) und einen Kollektor (10) aufweist,
**dadurch gekennzeichnet, dass**
die bei Verbinden einer Wechselspannungsquelle, die einer Gleichspannungsquelle zwischen dem Kollektor (10) und dem Emitter (11) des Leistungsmoduls überlagert ist, zwischen dem Emitter (11) und dem Kollektor (10) auftretende partielle Entladung gemessen wird, wobei eine vom Leistungsmodul (1) zwischen dem Kollektor (10) und dem Emitter (11) erhaltene Spannung Vtest immer Vtest>0 ist, so dass die Diode (4) an sich niemals leitend ist und das Leistungselement (3) während der Prüfung mit Hilfe einer zwischen dem Steuer-Gate (12) und dem Emitter (11) verbundenen Gleichspannungsquelle in einer Sperrstellung gehalten wird.

2. Verfahren zur Prüfung eines Leistungsmoduls (1) nach Anspruch 1, wobei das Modul (1) mehrere parallel geschaltete Leistungselemente (3), eine parallel und invers zu jedem Leistungselement (3) angeordnete Diode (4) aufweist, wobei das Leistungsmodul (1) mehrere Emitter (11), mehrere Kollektoren (10) und ein gemeinsam Steuer-Gate (12) aufweist,
**dadurch gekennzeichnet, dass**
die bei Verbinden der Wechselspannungsquelle, die der Gleichspannungsquelle zwischen den Emittern (11) und den Kollektoren (10) der Leistungselemente überlagert ist, zwischen den elektrisch miteinander verbundenen Emittern (11) und den elektrisch miteinander verbundenen Kollektoren (10) auftretende partielle Entladung gemessen wird, wobei die von den Leistungselementen (3) zwischen den Kollektoren (10) und den Emittern (11) erhaltene Spannung Vtest immer Vtest>0 ist, so dass die Dioden (4) an sich niemals leitend sind und die Leistungselemente (3) während der Prüfung mit Hilfe der zwischen dem Steuer-Gate (12) und den Emittern (11) verbundenen Gleichspannungsquelle in einer Sperrstellung gehalten wird.

3. Verfahren zur Prüfung eines Leistungsmoduls nach Anspruch 1 oder 2,
**dadurch gekennzeichnet, dass**
das wenigstens ein Leistungselement (3) ein IGBT-Element ist.

4. Vorrichtung zum Prüfen eines Leistungsmoduls (1) zur Verwendung in einem Verfahren gemäß einem der Ansprüche 1 bis 3,
**dadurch gekennzeichnet, dass**
die Vorrichtung zwei Klemmen (31, 32) aufweist, die durch die der Gleichspannungsquelle überlagerten Wechselspannungsquelle versorgt werden, wobei die Spannung Vtest zwischen den Klemmen (31) und (32) immer Vtest>0 ist und die Vorrichtung Einrichtungen (21) zum Messen der partiellen Entladung zwischen den beiden Klemmen (31, 32) aufweist.

5. Prüfvorrichtung nach Anspruch 4,
**dadurch gekennzeichnet, dass**
die beiden Klemmen (31, 32) durch einen Gleichspannungsgenerator (34) versorgt werden, der in Serie mit einem Wechselspannungsgenerator (33) angeordnet ist.

6. Prüfvorrichtung nach Anspruch 4,
**dadurch gekennzeichnet, dass**
die beiden Klemmen (31, 32) durch einen Gleichspannungsgenerator (34) versorgt werden, der parallel zu einem Wechselspannungsgenerator (33) angeordnet ist.

7. Prüfvorrichtung nach einem der Ansprüche 4 bis 6,
**dadurch gekennzeichnet, dass**
die Zuleitungsklemmen (31, 32) jeweils mit einem ersten Stromkreis (13), der die verschiedenen Kollektoren (10) des Leistungsmoduls (1) miteinander verbindet, und einem zweiten Stromkreis (14) der die verschiedenen Emitter (11) des Leistungsmoduls (1) miteinander verbindet, verbunden sind.
